# EUROPEAN PATENT SPECIFICATION

(11) **EP 2 541 323 B1**
(45) Date of publication and mention of the grant of the patent: **05.06.2013**
(21) Application number: 11171581.9
(22) Date of filing: 27.06.2011
(51) Int. Cl.: G03F 7/20, H01L 21/68

(54) **Manufacturing-process equipment**
Vorrichtung zur Ausführung eines Herstellungsverfahren
Équipement pour exécuter un procédé de fabrication

(43) Date of publication of application: 02.01.2013
(73) Proprietor: National Formosa University, Yunlin Hsien (TW)
(72) Inventor: Jywe, Wen-Yuh, Yunlin Hsien (TW); Shen, Jing-Chung, Yunlin Hsien (TW); Wu, Chia-Hung, Yunlin Hsien (TW)
(74) Representative: Caldwell, Judith Margaret

(56) References cited:
- EP-A2- 1 243 971
- US-A1- 2002 104 231
- US-A1- 2005 189 901
- US-A1- 2007 188 591
- LIU CHIEN-HUNG ET AL: "Improvement of the nonlinear dynamic response of a Z-tilts lead zirconate titanate-based compensation stage using the capacitor insertion method", REVIEW OF SCIENTIFIC INSTRUMENTS, AIP, MELVILLE, NY, US, vol. 80, no. 11, 23 November 2009 (2009-11-23), pages 115112-115112, XP012128008, ISSN: 0034-6748, DOI: 10.1063/1.3262504
- JYWE ET AL: "New nano-contouring measurement techniques for a nano-stage", INTERNATIONAL JOURNAL OF MACHINE TOOL DESIGN AND RESEARCH, PERGAMON PRESS, OXFORD, GB, vol. 46, no. 7-8, 1 June 2006 (2006-06-01) , pages 869-876, XP005389509, ISSN: 0020-7357, DOI: 10.1016/J.IJMACHTOOLS.2005.07.025

## Description

### 1. Field of the Invention

The present invention relates to a manufacturing-process equipment for workpieces, and more particularly to a manufacturing-process equipment that can be used to form nanometer structure pattern accurately and quickly on the workpieces.

### 2. Description of the Prior Arts

In general, conventional lithography technologies that are used to form nanometer structure pattern or nanometer holes on a workpiece include photolithography process, electron beam lithography technology, laser interference lithography technology and laser exposure lithography technology.

However, the working speed of the above-mentioned conventional lithography technologies is slow and the equipment or equipments for the conventional lithography technologies are expensive. Additionally, the design of the platform, the precision of the position of the platform, the optical positioning system and the temperature control will influence the working accuracy of the conventional lithography technologies.

Furthermore, a location platform of the conventional laser exposure lithography technology is used to carry workpieces and includes a long-stroke moving stage and a multi-axle short-travel moving platform. The long-stroke moving stage of the conventional location platform uses a servomotor with a ball screw, a linear motor or a voice coil motor as a driving source and uses the optics ruler and the optics read head to detect the position of the long-stroke moving stage. When the length of the optics ruler is longer than 1 meter, the working error will increase and this will influence the detecting result. Therefore, the precision of the conventional long-stroke moving stage cannot reach the nanometer level. The conventional multi-axle short-travel moving platform usually has a flexible structure made of piezoelectric material. The movement of the conventional multi-axle short-travel moving platform is about hundred micrometers, and this cannot form a large range of nanometer structure pattern or nanometer holes in the workpieces. In addition, other conventional laser exposure lithography technology are also disclosed in US 2005/189901 A1, EP 1 243 971 A2 and "Improvement of the nonlinear dynamic response of a Z-tilts lead zirconate titanate-based compensation stage using the capacitor insertion method" that is disclosed in 2009 by American Institute of Physics.

To overcome the shortcomings, the present invention provides a manufacturing-process equipment to mitigate or obviate the aforementioned problems.

The main objective of the present invention is to provide a manufacturing-process equipment, and more particularly to provide a manufacturing-process equipment that can be used to form nanometer structure pattern accurately and quickly on the workpieces. This objective has been met by providing a manufacturing process equipment according to claim 1, which has a platform assembly, a measurement feedback assembly and a laser-working assembly. The platform assembly has a base and a moving platform. The base has a mounting frame. The moving platform is mounted on the base and has a long-stroke moving stage and a piezo-driven stage. The long-stroke moving stage has a benchmark set and a driving device. The piezo-driven stage is connected to the long-stroke moving stage and has a working platform. The measurement feedback assembly is securely mounted on the platform assembly and has a laser interferometer, a reflecting device and a signal-receiving device. The laser-working assembly is mounted on the platform assembly, is electrically connected to the measurement feedback assembly and has a laser direct-writing head, a controlling interface device and a positioning interface device.

Other objectives, advantages and novel features of the invention will become more apparent from the following detailed description when taken in conjunction with the accompanying drawings.

### IN THE DRAWINGS:

Fig. 1 is a perspective view of a manufacturing-process equipment in accordance with the present invention;
Fig. 2 is a side view of the manufacturing-process equipment in Fig. 1;
Fig. 3 is an enlarged perspective view of a moving platform of a platform assembly of the manufacturing-process equipment in Fig. 1;
Fig. 4 is an enlarged perspective view of a moving platform of a platform assembly of the manufacturing-process equipment in Fig. 1 without a working platform;
Fig. 5 is an enlarged perspective view of a measurement feedback assembly of the manufacturing-process equipment in Fig. 1; and
Fig. 6 is an enlarged perspective view of a laser direct-writing head of a laser working assembly of the manufacturing-process equipment in Fig. 1.

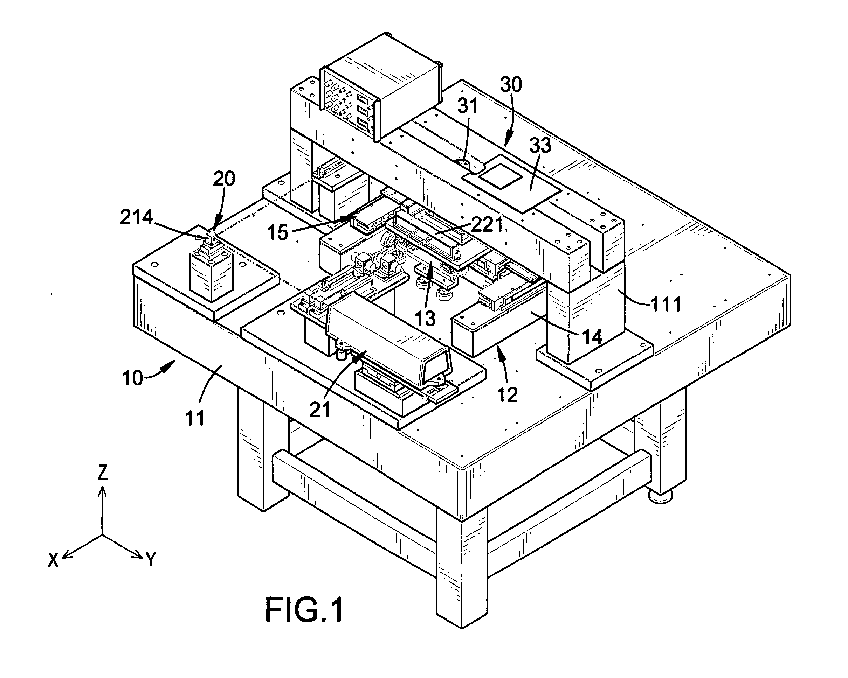

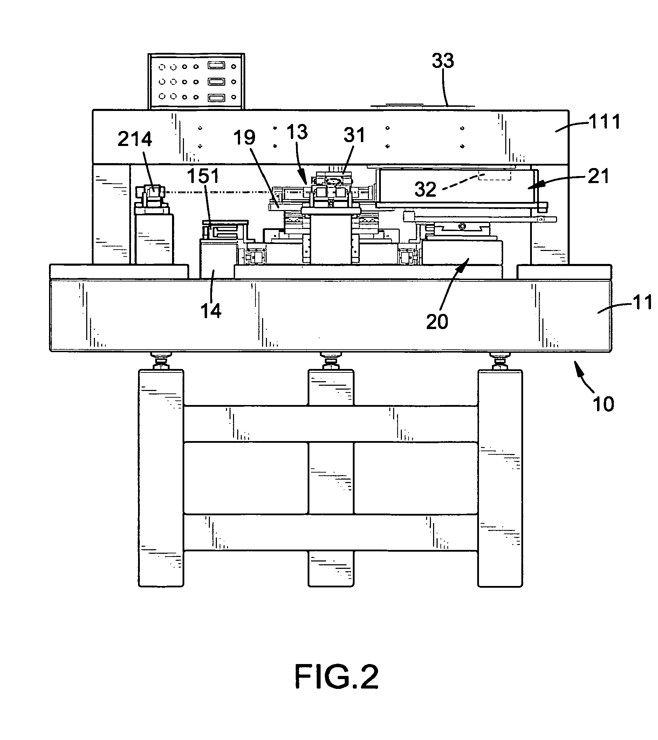

With reference to Figs. 1 to 4, a manufacturing-process equipment in accordance with the present invention comprises a platform assembly 10, a measurement feedback assembly 20 and a laser-working assembly 30.

The platform assembly 10 has a base 11 and a moving platform. The base 11 has a top and a mounting frame 111. The mounting frame 111 may be inversed U-shaped and is mounted on the top of the base 11 at the middle and has a top and a bottom.

The moving platform is mounted on the top of the base 11 below the mounting frame 111 and has a long-stroke moving stage 12 and a piezo-driven stage 13.

The long-stroke moving stage 12 is mounted on the top of the base 11 below the mounting frame 111 and has a benchmark set 14 and a driving device 15. The benchmark set 14 is H-shaped, is mounted securely on the top of the base 11 and may be made of granite. The thermal expansion coefficient of granite is low and the grinding precision can reach 2 micrometer / meter. The driving device 15 is mounted on the benchmark set 14 and has multiple linear motors 151. Each linear motor 151 is mounted on the benchmark set 14 and has an upper side, a lower side, multiple stators 152, an active cell 153 and a connecting board 154. The stators 152 are securely mounted on the sides of the linear motor 151 at intervals to form a magnetic leading rail. The linear precision of the magnetic leading rail can reach 0.4 micrometer /200 millimeter. The active cell 153 is movably mounted in the magnetic leading rail of the linear motor 151 between the stators 152 mounted on the sides of the linear motor 151 and has an outer end extending out of the linear motor 151. The connecting board 154 is connected to the outer end of the active cell 153 and has a connecting side opposite to the active cell 153.

The piezo-driven stage 13 is connected to the long-stroke moving stage 12 and has a loading frame 16, an adjustable device 17, multiple crossing-roller bearing devices 18 and a working platform 19.

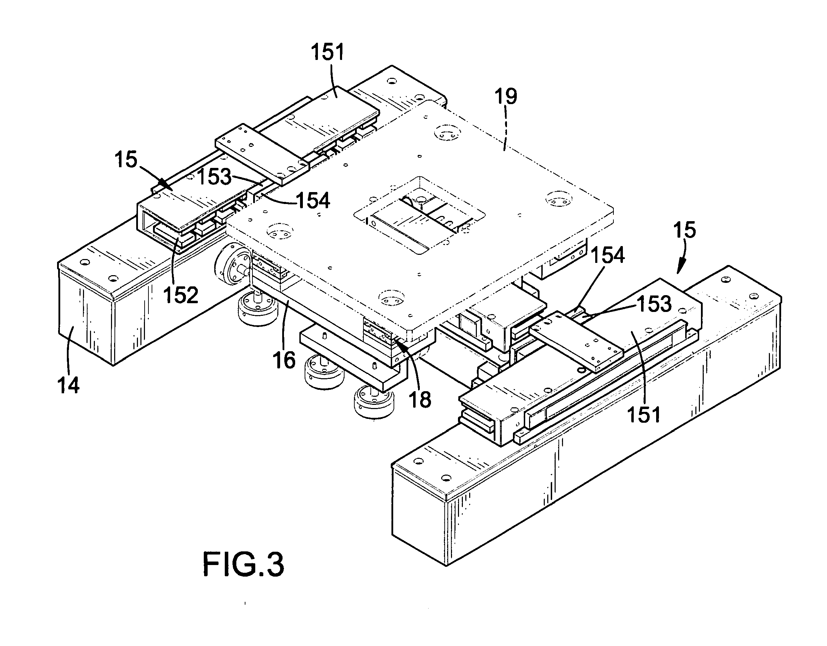

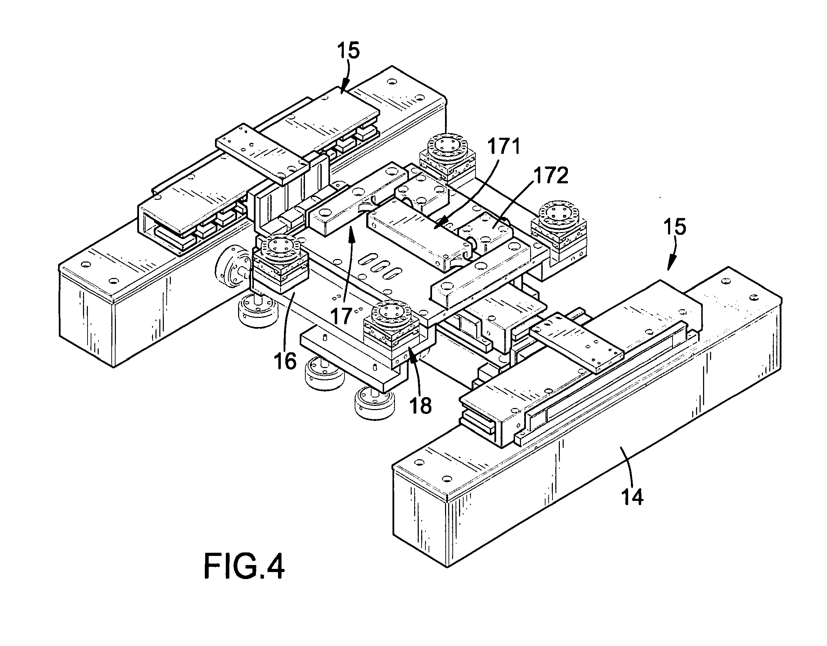

The loading frame 16 is connected to the connecting boards 154 of the driving device 15 as shown in Figs. 3 and 4, can be moved relative to the base 11 along X or Y direction by the long-stroke moving stage 12 and has a top. The adjustable device 17 is mounted on the top of the loading frame 16 and has a flexible seat 171 and multiple piezoelectric actuators 172. The flexible seat 171 is mounted on the top of the loading frame 16 and has a periphery. The piezoelectric actuators 172 are securely mounted on the top of the loading frame 16 and abut the periphery of the flexible seat 171. With reference to Fig. 4, the position of the flexible seat 171 can be adjusted or the flexible seat 171 can be slightly deformed by the pushing force of the piezoelectric actuators 172.

The crossing-roller bearing devices 18 are securely mounted on the top of the loading frame 16 beside the adjustable device 17 and each crossing-roller bearing device 18 can be moved along X and Y directions and has a top end. The working platform 19 is securely mounted on the flexible seat 171 and the top ends of the crossing-roller bearing devices 18 above the loading frame 16 and has a top face.

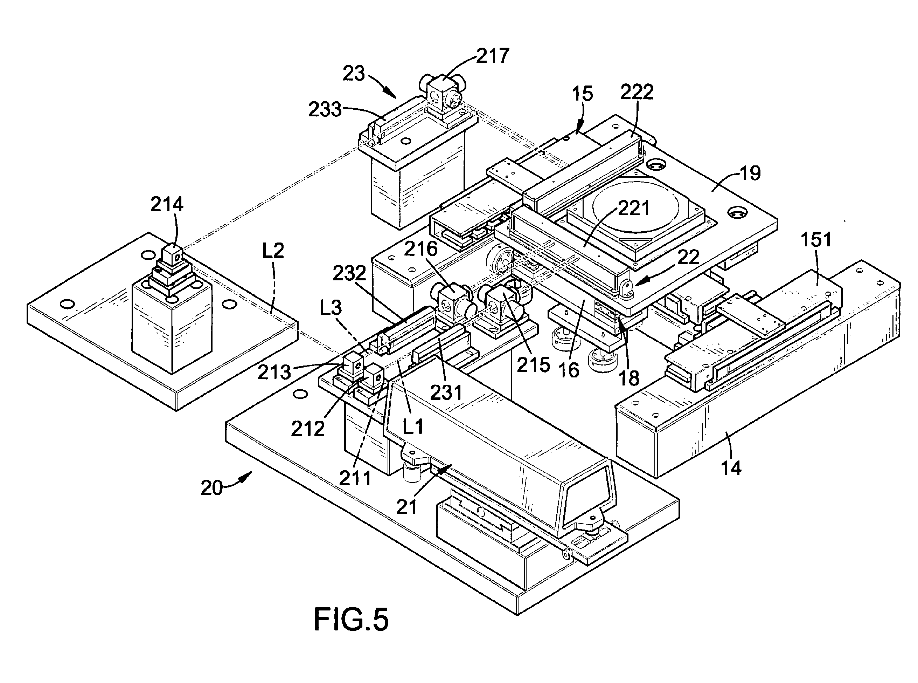

With reference to Figs. 1 and 5, the measurement feedback assembly 20 is securely mounted on the platform assembly 10 and has a laser interferometer 21, a reflecting device 22 and a signal-receiving device 23.

The laser interferometer 21 is securely mounted on the top of the base 11 and has a laser beam 211, a first beam splitter 212, a second beam splitter 213, a 90-degree reflecting mirror 214, a first interfere mirror 215, a second interfere mirror 216 and a third interfere mirror 217. The laser beam 211 is emitted from the laser interferometer 21. The beam splitters 212, 213 are securely mounted on the top of the base 11 at an interval and mounted on the emitting path of the laser beam 211. Preferably, the first beam splitter 212 is a 33%-67% spectral-ratio beam splitter and the second beam splitter 213 is a 50%-50% spectral-ratio beam splitter.

The 90-degree reflecting mirror 214 is securely mounted on the top of the base 11, aligns with the beam splitters 212, 213 and is used to change the emitting direction of the laser beam 211 at a right angle. The interfere mirrors 215, 216, 217 are mounted on the top of the base 11 and are used to receive the laser beam 211 split by the beam splitters 212, 213 and reflected by the 90-degree reflecting mirror 214. Preferably, the first interfere mirror 215 is used to receive the laser beam 211 split by the first beam splitter 212, the second interfere mirror 216 is used to receive the laser beam 211 split by the second beam splitter 213 and the third interfere mirror 217 is used to receive the laser beam 211 reflected by the 90-degree reflecting mirror 214.

The reflecting device 22 is mounted on the working platform 19 and has a first reflecting mirror 221 and a second reflecting mirror 222. The reflecting mirrors 221, 222 are securely mounted on the top face of the working platform 19 at a right angle and are used to reflect the laser beam 211 that passes through the interfere mirrors 215, 216, 217. Preferably, the first reflecting mirror 221 is used to reflect the laser beam 211 that passes through the first interfere mirror 215 and the second interfere mirror 216 and the second reflecting mirror 222 is used to reflect the laser beam 211 that passes through the third interfere mirror 217.

The signal-receiving device 23 is securely mounted on the top of the base 11 and has a first receiver 231, a second receiver 232 and a third receiver 233. The receivers 231, 232, 233 are used to receive the laser beams 211 reflected by the reflecting mirrors 221, 222 of the reflecting device 22. Preferably, the first receiver 231 is used to receive the laser beam 211 reflected by the first reflecting mirror 221 from the first interfere mirror 215 to detect the X-axis movement of the working platform 19, the second receiver 232 is used to receive the laser beam 211 reflected by the first reflecting mirror 221 from the second interfere mirror 216 to detect the X-axis movement of the working platform 19 and the third receiver 233 is used to receive the laser beam 211 reflected by the second reflecting mirror 222 from the third interfere mirror 217 to detect the Y-axis movement of the working platform 19. Furthermore, the X-axis movements detected by the first receiver 231 and the second receiver 232 can be used to calculate the error of the rotating angle (θz) of the working platform 19.

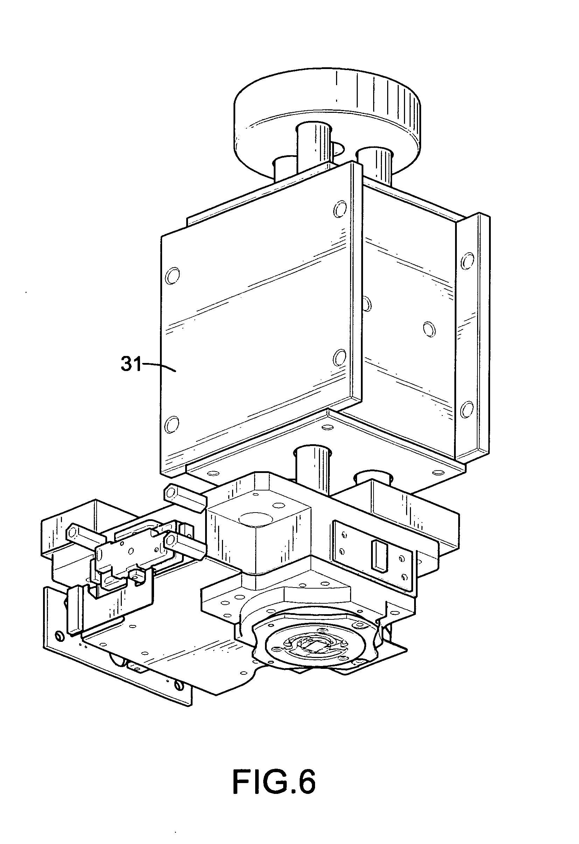

With reference to Figs. 1, 2 and 6, the laser-working assembly 30 is mounted on the platform assembly 10, is electrically connected to the measurement-feedback assembly 20 and has a laser direct-writing head 31, a controlling interface device 32 and a positioning interface device 33. The laser direct-writing head 31 is securely mounted on the mounting frame 111 of the base 11 above the working platform 19. Due to the laser direct-writing head 31 is securely mounted on the mounting frame 111 of the base 11 and the working platform 19 can be moved relative to the laser direct-writing head 31 by the H-shaped long-stroke moving stage 12 and the piezo-driven stage 13 to a desired actuating position of the laser direct-writing head 31 relative to the platform assembly 10 such that the laser direct-writing head 31 forms nanometer structure pattern or nanometer holes in the workpieces that is mounted on the movable working platform 19. The controlling interface device 32 is securely mounted on the bottom of the mounting frame 111, is electrically connected to the laser direct-writing head 31 and has a software to control the working power and the auto-focusing control of the laser direct-writing head 31. The positioning interface device 33 is mounted on the top of the mounting frame 111 above the controlling interface device 32, is electrically connected to the measurement feedback assembly 20 and the laser direct-writing head 31 and is used to receive the moving signals of the platform assembly 10 detected by the measurement feedback assembly 20 to compare the desired actuating position of the laser direct-writing head 31 relative to the platform assembly 10 and the moving signals detected by the measurement feedback assembly 20. Preferably, the positioning interface device 33 has a digital integrated circuit chip to compare the desired actuating position of the laser direct-writing head 31 relative to the platform assembly 10 and the moving signals detected by the measurement feedback assembly 20.

When the manufacturing-process equipment in accordance with the present invention is used to form nanometer structure pattern or nanometer holes in a workpiece, the workpiece is placed on the top face of the working platform 19. Then, with reference to Figs. 3 and 4, the moving platform of the platform assembly 10 is moved by two steps, the first step is moving the long-stroke moving stage 12 in a long distance by the linear motors 151 of the driving device 15. In the present invention, the moving range of the long-stroke moving stage 12 is 200 millimeter x 200 millimeter (X, Y). Additionally, the magnetic leading rails of the linear motors 151 can reduce the friction resistance between the stators 152 and the active cells 153 by the magnetic force between the active cells 153 and the stators 152 and this can improve the moving speed and the sensitivity of the long-stroke moving stage 12 and also can increase the useful life of the long-stroke moving stage 12.

After the first step, the second step of the moving platform is pushing or pulling the flexible seat 171 to move along the X-axis direction or to rotate about the Z-axis direction by the piezoelectric actuators 172. Furthermore, the crossing-roller bearing devices 18 also can be driven to rotate upward or downward about the Z-axis direction and move along X and Y directions with the flexible seat 171. Then, the adjustable device 17 and multiple crossing-roller bearing devices 18 of the piezo-driven stage 13 can allow the working platform 19 to accurately move in a minim distance along the X-axis and to rotate a minim angle along the z-axis.

After adjusting the location of working platform 19 of the platform assembly 10 by the adjustable device 17 and the crossing-roller bearing devices 18 of the piezo-driven stage 13, with reference to Fig. 5, the laser beam 211 is emitted from the laser interferometer 21. When the laser beam 211 emits into the first beam splitters 212, the intensity of the laser beam 211 is split to form a 33% spectral-ratio laser beam (L1) and a 67% spectral-ratio laser beam. The 33% spectral-ratio laser beam (L1) directly emits to the first interfere mirror 215 and the first reflecting mirror 221, is reflected back to the first interfere mirror 215 by the first reflecting mirror 221 and is received by the first receiver 231 to obtain the X-axis movement of the working platform 19. The 67% spectral-ratio laser beam emits to the second beam splitters 213, the intensity of the 67% spectral-ratio laser beam is split to form a 50% spectral-ratio laser beam (L2) and a 50% spectral-ratio laser beam (L3). The 50% spectral-ratio laser beam (L2) emits to and is reflected by the 90-degree reflecting mirror 214 and the third interfere mirror 217, is reflected back to the third interfere mirror 217 by the second reflecting mirror 222 and is received by the third receiver 233 to obtain the Y-axis movement of the working platform 19. The 50% spectral-ratio laser beam (L3) emits to the second interfere mirror 216 and the first reflecting mirror 221, is reflected back to the second interfere mirror 216 by the first reflecting mirror 221 and is received by the second receiver 232 to obtain the X-axis movement of the working platform 19. The X-axis movements of the working platform 19 received by the first receiver 231 and the second receiver 232 can be used to calculate the error of the rotating angle (θz) of the working platform 19. The laser beam 211 of the laser interferometer 21 can keep in a fine beam at a long distance and will not disperse and this can provide a wavelength with high brightness, stability and accuracy and the interference phenomenon can be easily observed by the laser interferometer 21. Therefore, the measurement feedback assembly 20 can accurately detect the X-axis movement, the Y-axis movement and the error of the rotating angle (θz) of the working platform 19.

When the position of the working platform 19 has been confirmed by the measurement feedback assembly 20, the digital integrated circuit chip of the positioning interface device 33 can be used to compare the desired actuating position of the laser direct-writing head 31 and the actual position of the working platform 19 detected by the measurement feedback assembly 20. Then, the laser direct-writing head 31 can quickly and accurately form a large range of nanometer structure pattern or nanometer holes in the workpieces.

The manufacturing-process equipment in accordance with the present invention uses two-step operations of the platform assembly 10 to achieve a long-stroke and nanometer-distance effect for the working platform 19. In the first step, the H-shaped long-stroke moving stage 12 can allow the working platform 19 to move in 200 millimeter x 200 millimeter (X, Y) and allow the laser-working assembly 30 to form a large range of nanometer structure pattern or nanometer holes in the workpieces on the working platform 19. In the second step, the piezo-driven stage 13 can allow the working platform 19 to move in a minim distance to correct the actual position of the working platform 19 and to allow the positioning precision of the platform assembly 10 to achieve the nano-level and to allow the manufacturing-process equipment in accordance with the present invention to form nanometer structure pattern or nanometer holes in the workpieces quickly and accurately.

Furthermore, the laser beam 211 of the measurement feedback assembly 20 can keep in a fine beam at a long distance and will not disperse and this can provide a wavelength with high brightness, stability and accuracy and the interference phenomenon can be easily observed by the laser interferometer 21. Therefore, the measurement feedback assembly 20 can accurately detect the X-axis movement, the Y-axis movement and the error of the rotating angle (θz) of the working platform 19. In addition, the positioning interface device 33 of the laser-working assembly 30 can be used to compare the desired actuating position of the laser direct-writing head 31 and the actual position of the working platform 19 detected by the measurement feedback assembly 20.

Therefore, the manufacturing-process equipment in accordance with the present invention can quickly and accurately form a large range of nanometer structure pattern or nanometer holes in the workpieces and this can reduce the cost of forming nanometer structure pattern in the workpieces to lift the competitiveness. Additionally, the platform assembly 10, the measurement feedback assembly 20 and the laser-working assembly 30 of the manufacturing-process equipment in accordance with the present invention can be assembled modularly to reduce the time of maintaining the manufacturing-process equipment.

Even though numerous characteristics and advantages of the present invention have been set forth in the foregoing description, together with details of the structure and features of the invention, the disclosure is illustrative only. Changes may be made in the details, especially in matters of shape, size, and arrangement of parts within the principles of the invention to the full extent indicated by the broad general meaning of the terms in which the appended claims are expressed.

## Claims

1. A manufacturing-process equipment comprising:
a platform assembly (10) having
a base (11) having
a top; and
a mounting frame (111) mounted on the top of the base (11) and having a top and a bottom; and
a moving platform mounted on the top of the base (11) below the mounting frame (111) and having
a long-stroke moving stage (12) mounted on the top of the base (11) below the mounting frame (111) and having
a benchmark set (14) being H-shaped and mounted securely on the top of the base (11); and
a driving device (15) mounted on the benchmark set (14) and having multiple linear motors (151) mounted on the benchmark set (14); and
a piezo-driven stage (13) connected to the long-stroke moving stage (12) and having a working platform (19) with a top face;
a measurement feedback assembly (20) securely mounted on the platform assembly (10) and having
a laser interferometer (21) securely mounted on the top of the base (11) to emit a laser beam (211);
a reflecting device (22) mounted on the top face of the working platform (19); and
a signal-receiving device (23) securely mounted on the top of the base (11) to receive the laser beam (211) reflected by the reflecting device (22); and
a laser-working assembly (30) mounted on the platform assembly (10), electrically connected to the measurement feedback assembly (20) and having
a laser direct-writing head (31) securely mounted on the mounting frame (111) of the base (11) above the working platform (19);
a controlling interface device (32) securely mounted on the bottom of the mounting frame (111), electrically connected to the laser direct-writing head (31) to control the working power and the auto-focusing control of the laser direct-writing head (31); and
a positioning interface device (33) mounted on the top of the mounting frame (111) above the controlling interface device (32), electrically connected to the measurement feedback assembly (20) and the laser direct-writing head (31) to receive moving signals of the platform assembly (10) detected by the measurement feedback assembly (20) to compare the desired actuating position of the laser direct-writing head (31) relative to the platform assembly (10) and the moving signals detected by the measurement feedback assembly (20).

2. The manufacturing-process equipment as claimed in claim 1,
wherein each linear motor (151) has
an upper side;
a lower side;
multiple stators (152) securely mounted on the sides of the linear motor (151) at intervals to form a magnetic leading rail;
an active cell (153) movably mounted in the magnetic leading rail of the linear motor (151) between the stators (152) mounted on the sides of the linear motor (151) and having an outer end extending out of the linear motor (151); and
a connecting board (154) connected to the outer end of the active cell (153) and having a connecting side opposite to the active cell (153).

3. The manufacturing-process equipment as claimed in claim 2,
wherein
the piezo-driven stage (13) has
a loading frame (16) connected to the connecting boards (154) of the driving device (15) and having a top;
an adjustable device (17) mounted on the top of the loading frame (16) and having
a flexible seat (171) mounted on the top of the loading frame (16) and having a periphery; and
multiple piezoelectric actuators (172) securely mounted on the top of the loading frame (16) and abutting the periphery of the flexible seat (171); and
multiple crossing-roller bearing devices (18) securely mounted on the top of the loading frame (16) beside the adjustable device (17) and each crossing-roller bearing device (18) having a top end; and
the working platform (19) is securely mounted on the flexible seat (171) and the top ends of the crossing-roller bearing devices (18) above the loading frame (16).

4. The manufacturing-process equipment as claimed in claim 1 or 3, wherein the laser interferometer (21) has
a first beam splitter (212) securely mounted on the top of the base (11) and mounted on an emitting path of the laser beam (211);
a second beam splitter (213) securely mounted on the top of the base (11) near the first beam splitter (212) and mounted on the emitting path of the laser beam (211);
a 90-degree reflecting mirror (214) securely mounted on the top of the base (11) and aligning with the beam splitters (212, 213) to change an emitting direction of the laser beam (211) at a right angle;
a first interfere mirror (215) mounted on the top of the base (11) to receive the laser beam (211) split by the first beam splitter (212);
a second interfere mirror (216) mounted on the top of the base (11) to receive the laser beam (211) split by the second beam splitter (213); and
a third interfere mirror (217) mounted on the top of the base (11) to receive the laser beam (211) reflected by the 90-degree reflecting mirror (214).

5. The manufacturing-process equipment as claimed in claim 4,
wherein the reflecting device (22) has
a first reflecting mirror (221) securely mounted on the top face of the working platform (19) to reflect the laser beam (211) emitted by the first interfere mirror (215) and the second interfere mirror (216); and
a second reflecting mirror (222) securely mounted on the top face of the working platform (19) at a right angle with the first reflecting mirror (221) to reflect the laser beam (211) emitted by the third interfere mirror (217).

6. The manufacturing-process equipment as claimed in claim 5,
wherein the signal-receiving device (23) has
a first receiver (231) securely mounted on the top of the base (11) to receive the laser beam (211) reflected by the first reflecting mirror (221) from the first interfere mirror (215);
a second receiver (232) securely mounted on the top of the base (11) to receive the laser beam (211) reflected by the first reflecting mirror (221) from the second interfere mirror (216); and
a third receiver (233) securely mounted on the top of the base (11) to receive the laser beam (211) reflected by the second reflecting mirror (222) from the third interfere mirror (217).

## Patentansprüche

1. Herstellungsprozessgerät, das Folgendes umfasst:
eine Plattformanordnung (10), die Folgendes aufweist:
eine Basis (11), die Folgendes aufweist:
eine Oberseite; und
einen Montagerahmen (111), der an der Oberseite der Basis (11) montiert ist und eine Oberseite und eine Unterseite aufweist; und
eine bewegliche Plattform, die an der Oberseite der Basis (11) unter dem Montagerahmen (111) montiert ist und Folgendes aufweist:
einen mit langem Hub beweglichen Träger (12), der an der Oberseite der Basis (11) unter dem Montagerahmen (111) montiert ist und Folgendes aufweist:
ein Referenzset (14), das H-förmig ist und fest an der Oberseite der Basis (11) montiert ist; und
eine Antriebsvorrichtung (15), die an dem Referenzset (14) montiert ist und mehrere an dem Referenzset (14) montierte Linearmotoren (151) aufweist; und
einen Träger (13) mit Piezoantrieb, der mit dem mit langem Hub beweglichen Träger (12) verbunden ist und eine Arbeitsplattform (19) mit einer oberen Oberfläche aufweist;
eine Messungs-Rückmeldungsanordnung (20), die fest an der Plattformanordnung (10) montiert ist und Folgendes aufweist:
ein Laserinterferometer (21), das fest an der Oberseite der Basis (11) montiert ist, um einen Laserstrahl (211) auszustrahlen;
eine Reflexionsvorrichtung (22), die an der oberen Oberfläche der Arbeitsplattform (19) montiert ist; und
eine Signalempfangsvorrichtung (23), die fest an der Oberseite der Basis (11) montiert ist, um den von der Reflexionsvorrichtung (22) reflektierten Laserstrahl (211) zu empfangen; und
eine an der Plattformanordnung (10) montierte Laserbearbeitungsanordnung (30), die elektrisch mit der Messungs-Rückmeldungsanordnung (20) verbunden ist und Folgendes aufweist:
einen Laser-Direktschreibkopf (31), der fest an dem Montagerahmen (111) der Basis (11) über der Arbeitsplattform (19) montiert ist;
eine Steuerschnittstellenvorrichtung (32), die fest an der Unterseite des Montagerahmens (111) montiert ist und elektrisch mit dem Laser-Direktschreibkopf (31) verbunden ist, um die Arbeitskraft und die automatische Fokussierungssteuerung des Laser-Direktschreibkopfs (31) zu steuern; und
eine Positionierungsschnittstellenvorrichtung (33), die an der Oberseite des Montagerahmens (111) über der Steuerschnittstellenvorrichtung (32) montiert ist und elektrisch mit der Messungs-Rückmeldungsanordnung (20) und dem Laser-Direktschreibkopf (31) verbunden ist, um von der Messungs-Rückmeldungsanordnung (20) erfasste Bewegungssignale der Plattformanordnung (10) zu empfangen, um die gewünschte Betätigungsposition des Laser-Direktschreibkopfs (31) relativ zu der Plattformanordnung (10) und die von der Messungs-Rückmeldungsanordnung (20) erfassten Bewegungssignale zu vergleichen.

2. Herstellungsprozessgerät nach Anspruch 1, wobei die Linearmotoren (151) jeweils Folgendes aufweisen:
eine obere Seite;
eine untere Seite;
mehrere Ständer (152), die in Abständen fest an den Seiten des Linearmotors (151) montiert sind, um eine magnetische Führungsschiene zu bilden;
eine aktive Zelle (153), die beweglich in der magnetischen Führungsschiene des Linearmotors (151) zwischen den an den Seiten des Linearmotors (151) montierten Ständern (152) montiert ist und ein äußeres Ende aufweist, das sich aus dem Linearmotor (151) heraus erstreckt; und
eine Verbindungsplatte (154), die mit dem äußeren Ende der aktiven Zelle (153) verbunden ist und eine Verbindungsseite gegenüber von der aktiven Zelle (153) aufweist.

3. Herstellungsprozessgerät nach Anspruch 2, wobei:
der Träger (13) mit Piezoantrieb Folgendes aufweist:
einen Laderahmen (16), der mit den Verbindungsplatten (154) der Antriebsvorrichtung (15) verbunden ist und eine Oberseite aufweist;
eine verstellbare Vorrichtung (17), die an der Oberseite des Laderahmens (16) montiert ist und Folgendes aufweist:
eine biegsame Aufnahme (171), die an der Oberseite des Laderahmens (16) montiert ist und einen Umfang aufweist; und
mehrere piezoelektrische Betätigungselemente (172), die fest an der Oberseite des Laderahmens (16) montiert sind und an den Umfang der biegsamen Aufnahme (171) anstoßen; und
mehrere Kreuzrollen-Lagervorrichtungen (18), die neben der verstellbaren Vorrichtung (17) fest an der Oberseite des Laderahmens (16) montiert sind, wobei jede Kreuzrollen-Lagervorrichtung (18) ein oberes Ende aufweist; und
wobei die Arbeitsplattform (19) über dem Laderahmen (16) fest an der biegsamen Aufnahme (171) und den oberen Enden der Kreuzrollen-Lagervorrichtungen (18) montiert ist.

4. Herstellungsprozessgerät nach Anspruch 1 oder 3, wobei das Laserinterferometer (21) Folgendes aufweist:
einen ersten Strahlteiler (212), der fest an der Oberseite der Basis (11) montiert ist und auf einem Strahlpfad des Laserstrahls (211) montiert ist;
einen zweiten Strahlteiler (213), der nah bei dem ersten Strahlteiler (212) fest an der Oberseite der Basis (11) montiert ist und auf dem Strahlpfad des Laserstrahls (211) montiert ist;
einen um 90 Grad reflektierenden Spiegel (214), der fest an der Oberseite der Basis (11) montiert ist und mit den Strahlteilern (212, 213) ausgerichtet ist, um eine Strahlrichtung des Laserstrahls (211) in einem rechten Winkel zu ändern;
einen ersten Interferenzspiegel (215), der an der Oberseite der Basis (11) montiert ist, um den von dem ersten Strahlteiler (212) geteilten Laserstrahl (211) zu empfangen;
einen zweiten Interferenzspiegel (216), der an der Oberseite der Basis (11) montiert ist, um den von dem zweiten Strahlteiler (213) geteilten Laserstrahl (211) zu empfangen;
einen dritten Interferenzspiegel (217), der an der Oberseite der Basis (11) montiert ist, um den von dem um 90 Grad reflektierenden Spiegel (214) reflektierten Laserstrahl (211) zu empfangen.

5. Herstellungsprozessgerät nach Anspruch 4, wobei die Reflexionsvorrichtung (22) Folgendes aufweist:
einen ersten Reflexionsspiegel (221), der fest an der oberen Oberfläche der Arbeitsplattform (19) montiert ist, um den von dem ersten Interferenzspiegel (215) und dem zweiten Interferenzspiegel (216) ausgestrahlten Laserstrahl (211) zu reflektieren; und
einen zweiten Reflexionsspiegel (222), der unter einem rechten Winkel zu dem ersten Reflexionsspiegel (221) fest an der oberen Oberfläche der Arbeitsplattform (19) montiert ist, um den von dem dritten Interferenzspiegel (217) ausgestrahlten Laserstrahl (211) zu reflektieren.

6. Herstellungsprozessgerät nach Anspruch 5, wobei die Signalempfangsvorrichtung (23) Folgendes aufweist:
einen ersten Empfänger (231), der fest an der Oberseite der Basis (11) montiert ist, um den von dem ersten Reflexionsspiegel (221) reflektierten Laserstrahl (211) von dem ersten Interferenzspiegel (215) zu empfangen;
einen zweiten Empfänger (232), der fest an der Oberseite der Basis (11) montiert ist, um den von dem ersten Reflexionsspiegel (221) reflektierten Laserstrahl (211) von dem zweiten Interferenzspiegel (216) zu empfangen;
einen dritten Empfänger (233), der fest an der Oberseite der Basis (11) montiert ist, um den von dem zweiten Reflexionsspiegel (222) reflektierten Laserstrahl (211) von dem dritten Interferenzspiegel (217) zu empfangen.

## Revendications

1. Equipement de processus de fabrication comprenant :
un ensemble de plate-forme (10) comportant
une base (11) présentant
une partie supérieure ; et
un cadre de montage (111) monté sur la partie supérieure de la base (11) et ayant une partie haute et une partie basse ; et
une plate-forme mobile montée sur la partie supérieure de la base (11) en dessous du cadre de montage (111) et présentant
une platine mobile à course longue (12) montée sur la partie supérieure de la base (11) en dessous du cadre de montage (111) et ayant
un gabarit (14) en forme de H monté solidement sur la partie supérieure de la base (11);et
un dispositif de commande (15) monté sur le gabarit (14) et comportant de multiples moteurs linéaires (151) montés sur le gabarit (14) ; et
une platine commandée par effet piézoélectrique (13) connectée à la platine mobile à course longue (12) et comportant une plate-forme de travail (19) présentant une face supérieure ;
un ensemble de renvoi de mesure (20) monté solidement sur l'ensemble de plate-forme (10) et comportant
un interféromètre laser (21) monté solidement sur la partie supérieure de la base (11) afin d'émettre un faisceau laser (211) ;
un dispositif réflecteur (22) monté sur la face supérieure de la plate-forme de travail (19) ; et
un dispositif récepteur de signal (23) monté solidement sur la partie supérieure de la base (11) afin de recevoir le faisceau laser (211) réfléchi par le dispositif réflecteur (22) ; et
un ensemble d'usinage au laser (30) monté sur l'ensemble de plate-forme (10), connecté électriquement à l'ensemble de renvoi de mesure (20) et comportant
une tête laser d'écriture directe (31) montée solidement sur le cadre de montage (111) de la base (11) au-dessus de la plate-forme de travail (19) ;
un dispositif d'interface de commande (32) monté solidement sur la partie basse du cadre de montage (111), connecté électriquement à la tête laser d'écriture directe (31) afin de commander la puissance de travail et la commande de mise au point automatique de la tête laser d'écriture directe (31) ; et
un dispositif d'interface de positionnement (33) monté sur la partie haute du cadre de montage (111) au-dessus du dispositif d'interface de commande (32), connecté électriquement à l'ensemble de renvoi de mesure (20) et à la tête laser d'écriture directe (31) pour recevoir des signaux de mouvement de l'ensemble de plate-forme (10) détectés par l'ensemble de renvoi de mesure (20) afin de comparer la position d'actionnement souhaitée de la tête laser d'écriture directe (31) par rapport à l'ensemble de plate-forme (10) et des signaux de mouvement détectés par l'ensemble de renvoi de mesure (20).

2. Equipement de processus de fabrication selon la revendication 1, dans lequel chaque moteur linéaire (151) comprend
un côté supérieur ;
un côté inférieur ;
de multiples stators (152) montés solidement sur les côtés du moteur linéaire (151) à des intervalles afin de former un rail de guidage magnétique ;
une cellule active (153) montée de façon mobile dans le rail de guidage magnétique du moteur linéaire (151) entre les stators (152) montés sur les côtés du moteur linéaire (151) et comportant une extrémité externe s'étendant hors du moteur linéaire (151) ; et
une carte de connexion (154) connectée à l'extrémité externe de la cellule active (153) et comportant un côté de connexion opposé à la cellule active (153).

3. Equipement de processus de fabrication selon la revendication 2, dans lequel la platine commandé par effet piézoélectrique (13) comporte
un cadre de chargement (16) connecté aux cartes de connexion (154) du dispositif de commande (15) et présentant une partie haute ;
un dispositif réglable (17) monté sur la partie haute du cadre de chargement (16) et présentant
un siège souple (171) monté sur la partie haute du cadre de chargement (16) et ayant une périphérie ; et
de multiples actionneurs piézoélectriques (172) montés solidement sur la partie haute du cadre de chargement (16) et jouxtant la périphérie du siège souple (171) ; et
de multiples dispositifs de roulements à rouleaux croisés (18) montés solidement sur la partie haute du cadre de chargement (16) à côté du dispositif réglable (17) et chaque dispositif de roulement à rouleaux croisés (18) ayant une extrémité supérieure ; et
la plate-forme de travail (19) est montée solidement sur le siège souple (171) et les extrémités supérieures des dispositifs de roulements à rouleaux croisés (18) au-dessus du cadre de chargement (16).

4. Equipement de processus de fabrication selon la revendication 1 ou 3, dans lequel l'interféromètre laser (21) comporte
un premier diviseur de faisceau (212) monté solidement sur la partie supérieure de la base (11) et monté sur un chemin émetteur du faisceau laser (211) ;
un second diviseur de faisceau (213) monté solidement sur la partie supérieure de la base (11) près du premier diviseur de faisceau (212) et monté sur le chemin émetteur du faisceau laser (211) ;
un miroir réflecteur à 90 degrés (214) monté solidement sur la partie supérieure de la base (11) et s'alignant avec les diviseurs de faisceau (212, 213) afin de changer un sens émetteur du faisceau laser (211) à angle droit ;
un premier miroir interférentiel (215) monté sur la partie supérieure de la base (11) afin de recevoir le faisceau laser (211) divisé par le premier diviseur de faisceau (212) ;
un deuxième miroir interférentiel (216) monté sur la partie supérieure de la base (11) afin de recevoir le faisceau laser (211) divisé par le second diviseur de faisceau (213) ; et
un troisième miroir interférentiel (217) monté sur la partie supérieure de la base (11) afin de recevoir le faisceau laser (211) réfléchi par le miroir réflecteur à 90 degrés (214).

5. Equipement de processus de fabrication selon la revendication 4, dans lequel le dispositif réflecteur (22) comporte
un premier miroir réflecteur (221) monté solidement sur la face supérieure de la plate-forme de travail (19) afin de réfléchir le faisceau laser (211) émis par le premier miroir interférentiel (215) et le deuxième miroir interférentiel (216) ; et
un second miroir réflecteur (222) monté solidement sur la face supérieure de la plate-forme de travail (19) à angle droit avec le premier miroir réflecteur (221) afin de réfléchir le faisceau laser (211) émis par le troisième miroir interférentiel (217).

6. Equipement de processus de fabrication selon la revendication 5, dans lequel le dispositif récepteur de signal (23) comporte
un premier récepteur (231) monté solidement sur la partie supérieure de la base (11) afin de recevoir le faisceau laser (211) réfléchi par le premier miroir réflecteur (221) depuis le premier miroir interférentiel (215) ;
un deuxième récepteur (232) monté solidement sur la partie supérieure de la base (11) afin de recevoir le faisceau laser (211) réfléchi par le premier miroir réflecteur (221) depuis le deuxième miroir interférentiel (216) ; et
un troisième récepteur (233) monté solidement sur la partie supérieure de la base (11) afin de recevoir le faisceau laser (211) réfléchi par le second miroir réflecteur (222) depuis le troisième miroir interférentiel (217).
